# EUROPEAN PATENT APPLICATION

(11) **EP 4 608 076 A1**
(43) Date of publication of application: **27.08.2025**
(21) Application number: 23880141.9
(22) Date of filing: 16.10.2023
(51) Int. Cl.: H05K 1/14, H05K 1/18, H04N 23/55, H04M 1/02

(54) **PRINTED CIRCUIT BOARD INCLUDING FIXING PART AND ELECTRONIC DEVICE COMPRISING SAME**

(30) Priority: 17.10.2022 KR 20220133209; 08.11.2022 KR 20220148015
(71) Applicant: Samsung Electronics Co., Ltd., Suwon-si, Gyeonggi-do 16677 (KR)
(72) Inventor: KIM, Bongchan, Suwon-si, Gyeonggi-do 16677 (KR); JUNG, Hwajoong, Suwon-si, Gyeonggi-do 16677 (KR); KIM, Taehwan, Suwon-si, Gyeonggi-do 16677 (KR); PARK, Jaehyoung, Suwon-si, Gyeonggi-do 16677 (KR); BYON, Kwangseok, Suwon-si, Gyeonggi-do 16677 (KR); JO, Jiyeon, Suwon-si, Gyeonggi-do 16677 (KR)
(74) Representative: Appleyard Lees IP LLP
(86) International application number: PCT/KR2023/015938
(87) International publication number: WO 2024/085564

(57) **Abstract**

An electronic device according to an embodiment of the present disclosure may comprise: a drive unit which includes a camera lens; a housing in which the drive unit is disposed and which encompasses the drive unit; and a printed circuit board which is disposed in at least a portion of the housing and the drive unit, wherein: the printed circuit board comprises a sensor part, a fixing part which is coupled to the housing, a connection part which extends while connecting the fixing part and the sensor part to each other, and a flexible part which surrounds at least a portion of the sensor part and is connected to the sensor part and the fixing part; and the connection part is severed when the fixing part is coupled to the housing.

## Description

### [Technical Field]

The disclosure relates to a printed circuit board including a fixing part and an electronic device including the same.

### [Background Art]

An electronic device including a camera may include a tiltable optical image stabilization (OIS) module. The tiltable optical image stabilization module can compensate for camera shake to ensure that a user captures a desired image.

The tiltable optical image stabilization module may include a driving part including a lens and a printed circuit board disposed on the driving part. The printed circuit board disposed on the driving part may include an image sensor and may include a sensor part that is movable and a flexible part that fixes the sensor part.

The above information may be provided as related art to aid in the understanding of the disclosure. No claim or determination is made as to the applicability of any of the foregoing as prior art to the disclosure.

### [Disclosure of Invention]

### [Technical Problem]

In order to implement the function of an optical image stabilization module, a driving part, a sensor part, and a fixing part need to be placed in predetermined positions. Since a movable sensor part of the optical image stabilization module is fixed using a flexible part, the sensor part may be moved even by a weak external impact during assembly. When the resistance of a flexible part is made high to prevent the movement of the sensor part, the operation of the optical image stabilization module may require a lot of current.

In the optical image stabilization module, an assembly guide for assembling a printed circuit board with other elements may be positioned at the outermost edge of the printed circuit board. For stability of the module assembly, the assembly guide may be thicker, which may lead to an increase in the overall size of the module.

### [Solution to Problem]

An electronic device according to an embodiment of the disclosure may include a driving part including a camera lens, a housing in which the driving part is disposed and which is configured to surround the perimeter of the driving part, and a printed circuit board disposed on at least a portion of the housing and the driving part.

The electronic device according to an embodiment of the disclosure may include a printed circuit board coupled to the housing in which the camera lens is disposed.

The printed circuit board according to an embodiment of the disclosure may include a sensor part, a fixing part coupled to the housing, a connection part extending while connecting the fixing part to the sensor part, and a flexible part which extends while surrounding at least a portion of the outer perimeter of the sensor part and is connected to the sensor part and the fixing part, wherein the connection part may be cut in case that the housing is coupled to the fixing part.

The printed circuit board according to an embodiment of the disclosure may be coupled to the housing in which the camera lens is disposed.

### [Advantageous Effects of Invention]

According to an embodiment of the disclosure, on the printed circuit board including the fixing part, and in the electronic device including the same, the fixing part may be used to assemble the sensor part of the printed circuit board in an accurate position.

According to an embodiment of the disclosure, on the printed circuit board including the fixing part, the fixing part may be disposed inside the outermost edge of the printed circuit board, thereby reducing the size of the electronic device (e.g., a camera module).

The technical problems to be solved herein are not limited to those described above, and other technical problems that have not been described will be clearly understood by those skilled in the art to which the disclosure belongs from the following description.

### [Brief Description of Drawings]

FIG. 1 is a block diagram of an electronic device in a network environment according to an embodiment.
FIG. 2 is an exploded perspective view of an electronic device according to an embodiment of the disclosure.
FIG. 3 illustrates a housing, a printed circuit board, and a bottom cover according to an embodiment of the disclosure.
FIG. 4 illustrates a printed circuit board according to an embodiment of the disclosure.
FIG. 5 illustrates a printed circuit board including a fixing part spaced apart from the perimeter of a flexible part according to an embodiment of the disclosure.
FIG. 6 illustrates a printed circuit board including a flexible part that is at least partially open according to an embodiment of the disclosure.
FIGS. 7A and 7B illustrate a housing and a printed circuit board according to an embodiment of the disclosure.

### [Mode for the Invention]

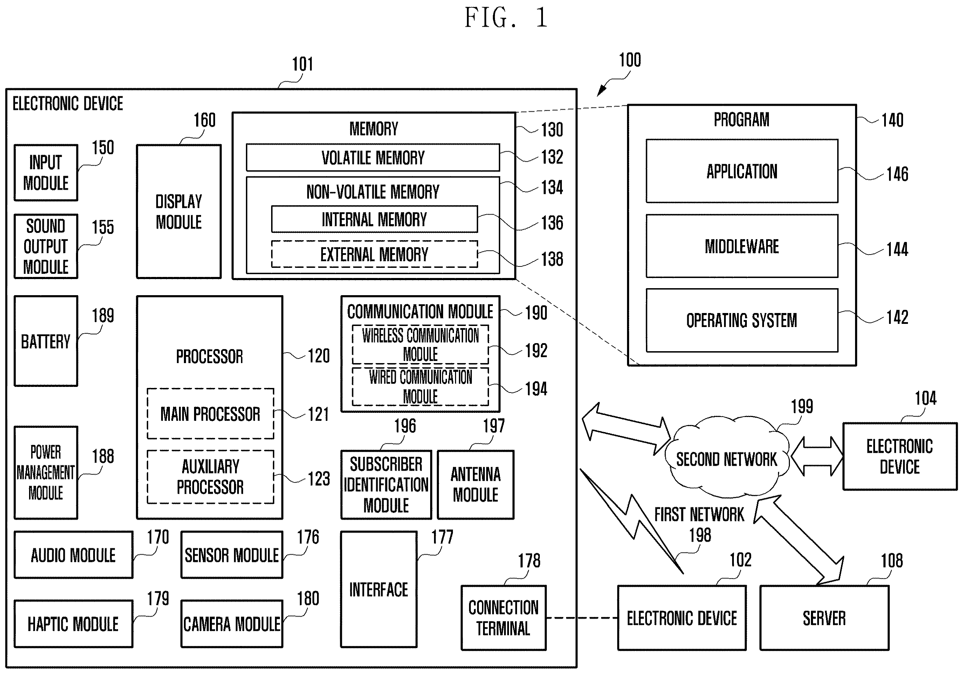

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

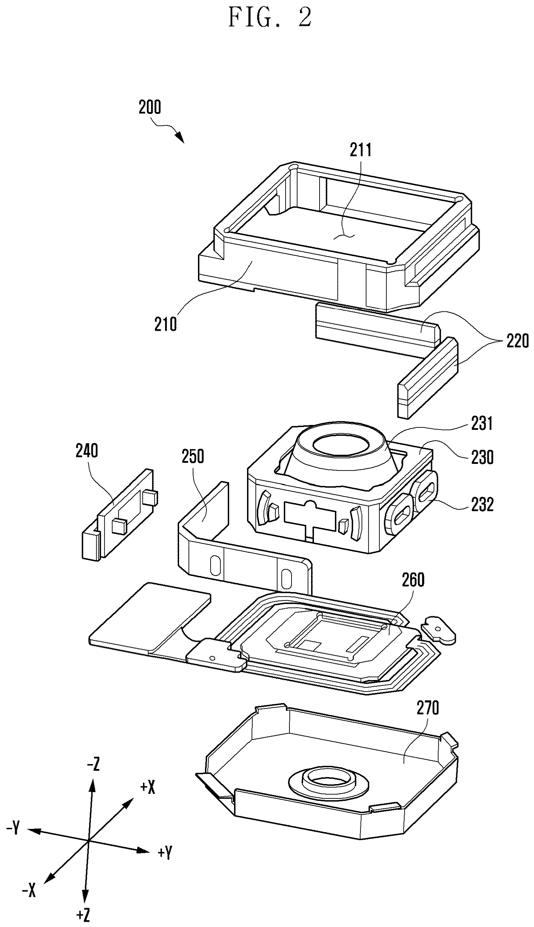

FIG. 2 is an exploded perspective view of an electronic device 200 according to an embodiment of the disclosure.

In describing the electronic device 200 according to an embodiment of the disclosure, the width direction of the electronic device 200 may refer to the x-axis direction, and the length direction of the electronic device 200 may refer to the y-axis direction. The height direction of the electronic device 200 may refer to the z-axis direction.

The electronic device 200, according to an embodiment of the disclosure, may refer to the electronic device 101 in FIG. 1, or may refer to at least a portion of the electronic device 101 in FIG. 1. For example, the electronic device 200 may refer to the camera module 180 of the electronic device 101 in FIG. 1.

The electronic device 200 according to an embodiment of the disclosure may include a housing 210, a magnet 220, a driving part 230, a sub-housing 240, a rotation guide 250, a printed circuit board 260, and a bottom cover 270.

In an embodiment, the housing 210 may be disposed while surrounding the perimeter of the driving part 230. For example, when the driving part 230 includes surfaces facing the width direction (e.g., the x-axis direction) and the length direction (e.g., the y-axis direction) of the electronic device 200, the housing 210 may be disposed to surround each surface of the driving part 230.

In an embodiment, the housing 210 may include a housing opening 211. The driving part 230 may be at least partially inserted into the housing opening 211 of the housing 210.

In an embodiment, the housing 210 and the printed circuit board 260 may be coupled to each other. For example, at least a portion of the housing 210 may be coupled to the printed circuit board 260, and the relative position of the printed circuit board 260 relative to the driving part 230 may be fixed.

In an embodiment, the driving part 230 may include a camera lens 231 and/or a coil 232 therein. For example, the coil 232 may be disposed on at least one of the side surfaces of the driving part 230.

In an embodiment, the driving part 230 may be configured to implement an optical image stabilization (OIS) function. For example, the driving part 230 may serve to rotate or move the camera lens 231 and a portion (e.g., an image sensor) of the printed circuit board 260 together to substantially align the optical axis with an imaginary axis connecting a subject to the center of the electronic device 200 (e.g., the camera module 180 in FIG. 1).

In an embodiment, the driving part 230 may include an autofocus (AF) actuator (not shown) that can implement the upward and downward movement of the camera lens 231. For example, an autofocus actuator (not shown) capable of implementing autofocus may be positioned inside the driving part 230.

In an embodiment, the magnet 220 may be disposed in the housing 210. For example, the magnet 220 may be disposed on at least one of surfaces surrounding the housing opening 211 of the housing 210.

In an embodiment, two magnets 220 may be disposed in the housing 210. For example, each of the two magnets 220 may be disposed on at least one of the surfaces surrounding the housing opening 211 of the housing 210. One magnet 220 may be disposed on the surface, among the surfaces surrounding the housing opening 211, which faces the negative x-axis direction, and the other magnet 220 may be disposed on the surface, among the surfaces surrounding the housing opening 211, which faces the negative y-axis direction.

In an embodiment, the magnet 220 disposed in the housing 210 and the coil 232 of the driving part 230 may be disposed in positions corresponding to each other. For example, when the magnet 220 is disposed on a surface facing the negative x-axis direction in the housing 210, the coil 232 may be disposed on a surface of the driving part 230 facing the positive x-axis direction.

In an embodiment, the positions of the magnet 220 and the coil 232 may be interchanged. For example, the magnet 220 may be disposed in the driving part 230 and the coil 232 may be disposed in the housing 210.

In an embodiment, the magnet 220 and the coil 232 may be configured to implement an optical image stabilization (OIS) function. For example, the driving part 230 may use the electromagnetic force formed between the magnet 220 and the coil 232 to rotate or move the camera lens 231, thereby implementing an optical image stabilization function.

In an embodiment, the rotation guide 250 may be formed to extend in the width direction (e.g., the x-axis direction) and the length direction (e.g., the y-axis direction) of the electronic device 200. For example, the rotation guide 250 may extend in the width direction and length direction of the electronic device 200 along the side surfaces of the driving part 230 on which the magnet 220 and the coil 232 are not disposed.

In an embodiment, the rotational guide 250 may include a guide rail (not shown) in at least a portion thereof. For example, the guide rail (not shown) may be disposed at positions corresponding to the side surfaces of the driving part 230 on which the rotation guide 250 is disposed.

In an embodiment, one surface of the rotation guide 250 may refer to a surface of the rotation guide 250 facing the driving part 230. The other surface of the rotation guide 250 may refer to a surface opposite to the one surface of the rotation guide 250.

In an embodiment, a ball rail (not shown) may be disposed on one surface of the rotation guide 250. The ball rail (not shown) disposed on the one surface of the rotation guide 250 may be configured to correspond to one surface of the driving part 230 (e.g., a surface of the driving part 230 facing the rotation guide 250). A ball (not shown) may be disposed between the one surface of the rotation guide 250 and the one surface of the driving part 230.

In an embodiment, the other surface of the rotation guide 250 may be disposed to face the sub-housing 240 or the housing 210. A ball (not shown) may be disposed between the other surface of the rotation guide 250 and the sub-housing 240 or the housing 210.

In an embodiment, the rotation guide 250 may include an adsorption magnet (not shown) and a yoke (not shown) to which a ball bearing (not shown) can be fixed. At least one of the adsorption magnet (not shown) and the yoke may be fixedly disposed on the rotation guide 250.

In an embodiment, the sub-housing 240 may be disposed on at least one side of the rotating guide 250. For example, referring to FIG. 2, the sub-housing 240 may be disposed on a surface of the rotation guide 250 facing the negative y-axis direction.

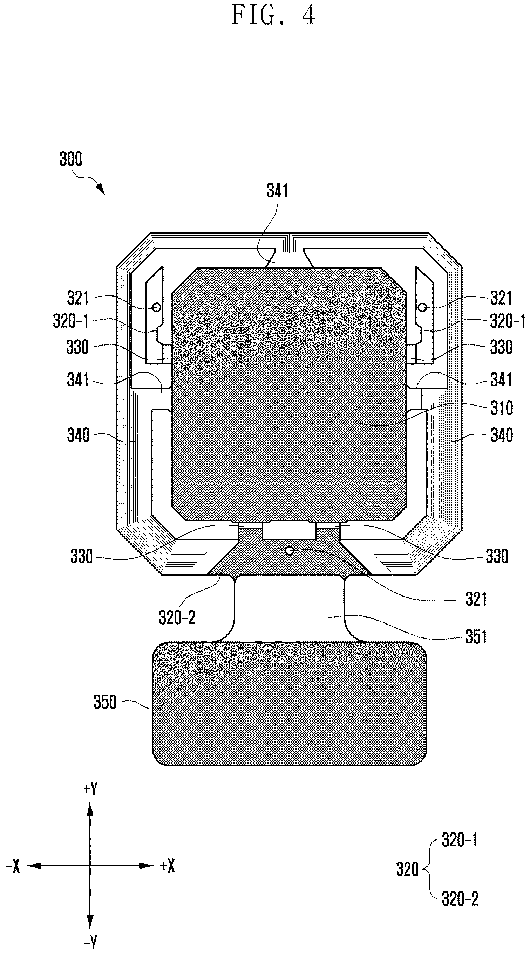

In an embodiment, the printed circuit board 260 may be disposed in one direction relative to the driving part 230. For example, the printed circuit board 260 may be disposed in the positive z-axis direction relative to the driving part 230. The printed circuit board 260 may include an image sensor (e.g., the sensor part 310 in FIG. 4) in at least a portion thereof.

In an embodiment, the bottom cover 270 may be disposed in one direction relative to the printed circuit board 260. For example, the bottom cover 270 may be disposed in the positive z-axis direction relative to the printed circuit board 260.

In an embodiment, relative to the height direction (e.g., the z-axis direction) of the electronic device 200, the driving part 230, the printed circuit board 260, and the bottom cover 270 may be disposed in order. For example, the printed circuit board 260 may be disposed in the positive z-axis direction relative to the driving part 230. The bottom cover 270 may be disposed in the positive z-axis direction relative to the printed circuit board 260.

The electronic device 200 according to an embodiment of the disclosure may be a tiltable optical image stabilization (OIS) module. The tiltable optical image stabilization module may allow the camera lens 231 of the driving part 230 and a portion (e.g., an image sensor) of the printed circuit board 260 to tilt together.

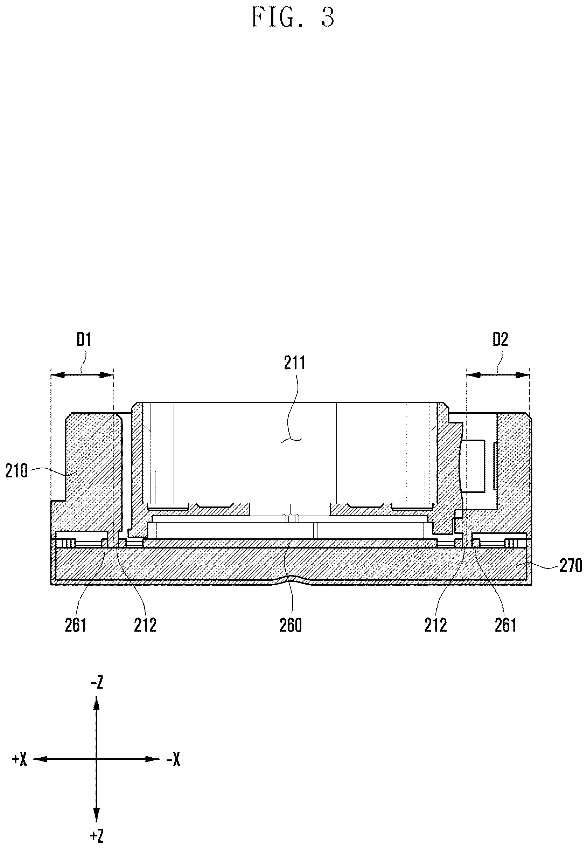

FIG. 3 illustrates a housing 210, a printed circuit board 260, and a bottom cover 270 according to an embodiment of the disclosure.

FIG. 3 may be a view illustrating cross-sections of the housing 210, the printed circuit board 260, and the bottom cover 270 according to an embodiment, parallel to the width direction (e.g., the x-axis direction) and the height direction (e.g., the z-axis direction) of an electronic device 200.

FIG. 3 may be a view illustrating a state in which the housing 210, the printed circuit board 260, and the bottom cover 270 according to an embodiment are coupled to each other.

In an embodiment, relative to the height direction (e.g., the z-axis direction) of the electronic device 200, the housing 210, the printed circuit board 260, and the bottom cover 270 may be disposed in order. For example, the printed circuit board 260 may be disposed in the positive z-axis direction relative to the housing 210. The bottom cover 270 may be disposed in the positive z-axis direction relative to the printed circuit board 260.

In an embodiment, the housing 210 may include a housing opening 211 and/or a coupling region 212 in which a driving part 230 (see FIG. 2) is disposed.

In an embodiment, the coupling region 212 may be a region that protrudes and extends from the housing 210 toward the printed circuit board 260. For example, referring to FIG. 3, the coupling region 212 of the housing 210 may extend such that at least a portion of the housing 210 protrudes in the positive z-axis direction compared to other regions of the housing 210.

In an embodiment, one surface of the printed circuit board 260 may refer to a surface facing the negative z-axis direction relative to the printed circuit board 260, and the other surface of the printed circuit board 260 may refer to a surface facing the positive z-axis direction relative to the printed circuit board 260.

In an embodiment, the housing 210 may be disposed on one surface of the printed circuit board 260. The bottom cover 270 may be disposed on the other surface of the printed circuit board 260.

In an embodiment, the housing 210 may include a plurality of coupling regions 212. For example, referring to FIG. 3, two coupling regions 212 may each be formed at symmetrical positions relative to the center of the housing 210 in the width direction (e.g., the x-axis direction).

Although FIG. 3 illustrates that two coupling regions 212 of the housing 210 are formed, this is exemplary, and the number of coupling regions 212 may not be limited thereto. For example, the housing 210 may include three or more coupling regions 212, and each coupling region 212 may be coupled to a corresponding region of the printed circuit board 260.

In an embodiment, the printed circuit board 260 may include fixing regions 261. The fixing regions 261 of the printed circuit board 260 may be formed at positions corresponding to the coupling regions 212 of the housing 210. For example, when the housing 210 and the printed circuit board 260 are coupled to each other, the coupling regions 212 of the housing 210 and the fixing regions 261 of the printed circuit board 260 may be disposed at positions corresponding to each other.

The coupling regions 212 of the housing 210 may be inserted into at least portions of the coupling regions 261 of the printed circuit board 260. The fixing regions 261 may include shapes (e.g., fixing part holes 321, see FIG. 4) into which the protruding portions of the coupling regions 212 may be inserted. The coupling regions 212 are inserted into the fixing regions 261 and the printed circuit board 260 may be fixed while being disposed in the housing 210.

In an embodiment, one side of the housing 210 may refer to a side surface of the housing 210 that faces the positive x-axis direction. The other side of the housing 210 may refer to a side surface of the housing 210 that faces the negative x-axis direction.

In an embodiment, the coupling regions 212 of the housing 210 may be disposed at predetermined distances from the one side of the housing 210 and the other side of the housing 210. For example, the coupling regions 212 may be positioned at separation distance D1 and D2 from the one side and the other side of the housing 210. The coupling region 212 may be positioned at a first separation distance D1 from the one side of the housing 210. The coupling region 212 may be positioned at a second separation distance D2 from the other side of the housing 210.

In FIG. 3, the first separation distance D1 and the second separation distance D2 are shown to have the same length, but this is exemplary and the length of the first separation distance D1 and the second separation distance D2 may not be limited thereto. For example, the first separation distance D1 may be formed longer or shorter than the second separation distance D2.

In an embodiment, the fixing regions 261 of the printed circuit board 260, into which the coupling regions 212 are inserted, may also be positioned at distances approximately equal to the separation distances D1 and D2 from the one side and the other side of the housing 210. For example, the fixing region 261 of the printed circuit board 260 may be positioned at the first separation distance D1 from the one side of the housing 210. The fixing region 261 of the printed circuit board 260 may be positioned at the second separation distance D2 from the other side of the housing 210.

In an embodiment, the positions where the coupling regions 212 of the housing 210 and the fixing regions 261 of the printed circuit board 260 are disposed (e.g., positions spaced apart from the one side and the other side of the housing 210 by the separation distance D1) may be an empty space that is not used by any other element of the electronic device 200.

In an embodiment, the size of the electronic device 200 may refer to the width-wise length, length-wise length, and/or height-wise length of the electronic device 200.

In an embodiment, the printed circuit board 260 may be disposed to be spaced from the driving part 230 (see FIG. 2) by a predetermined length or more in the height direction (e.g., the z-axis direction). To maintain spacing between the printed circuit board 260 and the driving part 230, the outermost portion of the bottom cover 270 (e.g., the end portions of the bottom cover 270 in the x-axis and y-axis directions) may be formed to protrude in a plate shape in the height direction (e.g., the z-axis direction) of the electronic device 200 and may be disposed on the outermost portion of the housing 210 (e.g., the end portions of the housing 210 in the x-axis and y-axis directions).

In an embodiment, when portions in which the housing 210 and the printed circuit board 260 coupled to each other are positioned at a distance from one side and the other side of the housing 210, the portions in which the housing 210 is coupled to the printed circuit board 260 may not be disposed at the outermost portions of the housing 210 and the bottom cover 270, thereby relatively reducing the width-wise (e.g., the x-axis direction) length and length-wise (e.g., the y-axis direction) length of the electronic device 200.

In an embodiment, when coupling portions of the housing 210 and the printed circuit board 260 are positioned at a distance from one side and the other side of the housing 210, the size of the electronic device 200 may be reduced compared to when the coupling portions are formed at the outermost portion of the housing 210. For example, when coupling portions of the housing 210 and the printed circuit board 260 are formed at the outermost portion of the housing 210, the thickness of the coupling portions positioned at the outermost portion of the housing 210 may be relatively thicker, thereby increasing the size of the electronic device 200 (e.g., the height-wise length of the electronic device 200).

In an embodiment, when the coupling portions of the housing 210 and the printed circuit board 260 are positioned at a distance from one side and the other side of the housing 210, the coupling portions may be disposed in empty space, which is not used, in the electronic device 200, and the outermost portion of the housing 210 may be formed as only a structure that abuts the outermost portion of the bottom cover 270 without any coupling portion, thereby relatively reducing the size of the electronic device 200 (e.g., the width-wise length and/or height-wise length of the electronic device 200).

FIG. 4 illustrates a printed circuit board 300 according to an embodiment of the disclosure.

In describing the printed circuit board 300 according to an embodiment of the disclosure, the width direction of the printed circuit board 300 may refer to the x-axis direction, and the length direction of the printed circuit board 300 may refer to the y-axis direction.

The printed circuit board 300 illustrated in FIG. 4 may refer to the printed circuit board 260 in FIG. 2, or may include at least a portion of the printed circuit board 260 in FIG. 2.

The printed circuit board 300 illustrated in FIG. 4 may include a sensor part 310, a fixing part 320, a connection part 330, a flexible part 340, and/or a connector 350.

In an embodiment, the sensor part 310 may be a region in which an image sensor is included. The sensor part 310 may move along the direction in which the driving part 230 (see FIG. 2) moves. For example, when the camera lens 231 (see FIG. 2) of the driving part 230 (see FIG. 2) is tilted, the sensor part 310 may tilt in a direction substantially the same as the direction in which the camera lens 231 (see FIG. 2) is tilted.

In an embodiment, the sensor part 310 may extend in the width direction and length direction of the printed circuit board 300. For example, the sensor part 310 may extend in the width direction and the length direction of the printed circuit board 300 and may be formed in the shape of a plate having a thickness.

In an embodiment, the fixing part 320 and the flexible part 340 may be disposed outside the sensor part 310.

In an embodiment, the flexible part 340 may be disposed while surrounding at least a portion of the outer perimeter of the sensor part 310. For example, the flexible part 340 may be formed to extend in the width direction and length direction of the printed circuit board 300 outside the perimeter of the sensor part 310.

In an embodiment, at least a portion of the flexible part 340 may be spaced apart from the sensor part 310 in the width direction (e.g., the x-axis direction) of the printed circuit board 300. The region of the flexible part 340 spaced apart from the sensor part 310 in the width direction (e.g., the x-axis direction) of the printed circuit board 300 may extend in the length direction (e.g., the y-axis direction) of the printed circuit board 300.

In an embodiment, at least a portion of the flexible part 340 may be spaced apart in the longitudinal direction (e.g., the y-axis direction) of the sensor part 310 and the printed circuit board 300. The regions of the flexible part 340 that are spaced apart in the length direction (e.g., the y-axis direction) of the sensor part 310 and the printed circuit board 300 may extend in the width direction (e.g., the x-axis direction) of the printed circuit board 300.

In an embodiment, the flexible part 340 may include a connection region 341 that is connected to the sensor part 310.

In an embodiment, the connection region 341 of the flexible part 340 may extend in a direction substantially perpendicular to the direction in which other regions of the flexible part 340 extend. For example, when the region of the flexible part 340 extends in the length direction (e.g., the y-axis direction) of the printed circuit board 300, the connection region 341 may extend in the width direction (e.g., the x-axis direction) of the printed circuit board 300 to be connected to the sensor part 310.

In FIG. 4, the connection region 341 is shown as being connected to the length-wise center or width-wise center of the sensor part 310, but this is exemplary, and the position where the connection region 341 is disposed may not be limited thereto.

In an embodiment, the fixing part 320 of the printed circuit board 300 may be a region that is fixed to another portion of the electronic device 200 (see FIG. 2). For example, the fixing part 320 may be coupled to the housing 210 (see FIG. 2), and the position the fixing part 320 may be fixed.

In an embodiment, the printed circuit board 300 may include at least one fixing part 320. Referring to FIG. 4, the printed circuit board 300 is illustrated as including three fixing parts 320, but this is exemplary and the number of fixing parts 320 may not be limited thereto. For example, the printed circuit board 300 may include one fixing part 320.

In an embodiment, the fixing part 320 may include a fixing part hole 321. The fixing part 320 may be fixed to another portion of the electronic device 200 (see FIG. 2) via the fixing part hole 321. For example, the housing 210 (see FIG. 3) may include a coupling region 212 (see FIG. 3) in at least a portion thereof, and the coupling region 212 (see FIG. 3) may be inserted into the fixing part hole 321 to couple the fixing part 320 of the printed circuit board 300 to the housing 210 (see FIG. 3).

In an embodiment, the fixing part 320 may include a first fixing part 320-1 and/or a second fixing part 320-2.

In an embodiment, the first fixing part 320-1 may be positioned on one side and the other side of the sensor part 310. For example, the first fixing part 320-1 may be positioned in the positive x-axis direction and/or the negative x-axis direction relative to the sensor part 310.

In an embodiment, the fixing part 320 may include two first fixing parts 320-1. The two first fixing parts 320-1 may be disposed in symmetrical positions relative to the sensor part 310. For example, one first fixing part 320-1 may be positioned in the negative x-axis direction relative to the sensor part 310, and the other first fixing part 320-1 may be positioned in the positive x-axis direction relative to the sensor part 310.

In an embodiment, the second fixing part 320-2 may be positioned on a side surface perpendicular to one side and the other side of the sensor part 310. For example, the second fixing part 320-2 may be positioned on a side surface of the sensor part 310 facing the negative y-axis direction.

In an embodiment, the outward direction of the sensor part 310 may refer to a direction away from the sensor part 310 with respect to the perimeter of the sensor part 310.

In an embodiment, the fixing part 320 and the flexible part 340 may be position in the outward direction of the sensor part 310.

In an embodiment, at least a portion of the fixing part 320 may be positioned closer to the sensor part 310 compared to the flexible part 340. For example, the first fixing part 320-1 may be disposed between the sensor part 310 and the flexible part 340. One first fixing part 320-1 may be disposed in the negative x-axis direction relative to the sensor part 310, and the flexible part 340 may be disposed in the negative x-axis direction relative to the one first fixing part 320-1. The other first fixing part 320-1 may be disposed in the positive x-axis direction relative to the sensor part 310, and the flexible part 340 may be disposed in the positive x-axis direction relative to the other first fixing part 320-1.

In an embodiment, at least a portion of the fixing part 320 may be connected to the flexible part 340. For example, one end and the other end of the second fixing part 320-2 may be connected to the flexible part 340. Referring to FIG. 4, the one end of the second fixing part 320-2 may refer to an end positioned in the negative x-axis direction relative to the second fixing part 320-2, and the other end of the second fixing part 320-2 may refer to an end positioned in the positive x-axis direction relative to the second fixing part 320-2.

In an embodiment, the distance by which at least a portion of the fixing part 320 is spaced apart from the sensor part 310 may be formed to be substantially equal to the distance by which at least a portion of the flexible part 340 is spaced apart from the sensor part 310. For example, the distance by which at least a portion of the second fixing part 320-2 is spaced apart from the sensor part 310 in the negative y-axis direction may be formed to be substantially equal to the distance by which a portion of the flexible part 340 is spaced apart from the sensor part 310 in the negative y-axis direction.

In an embodiment, the connection part 330 may be a region that connects the sensor part 310 to the fixing part 320.

Referring to FIG. 4, the first fixing part 320-1 may be connected, at one end thereof, to the sensor part 310 via the connection part 330. For example, the connection part 330 may be positioned at an end of the first fixing part 320-1 that faces the negative y-axis direction. The connection part 330 may extend from the first fixing part 320-1 toward the sensor part 310.

Referring to FIG. 4, the second fixing part 320-2 may be connected to the sensor part 310 via the connection part 330. For example, the second fixing part 320-2 may be connected to two connection parts 330, and each of the two connection parts 330 may extend from the second fixing part 320-2 toward the sensor part 310.

In an embodiment, the connection part 330 may be removed after coupling of the printed circuit board 300 to another region (e.g., the housing 210, see FIG. 2) of the electronic device 200 is complete. For example, after the coupling of the printed circuit board 300 to another region (e.g., the housing 210, see FIG. 2) of the electronic device 200 is complete, the connection part 330 may be cut to separate the fixing part 320 from the sensor part 310.

In an embodiment, the removal of the connection part 330 may be accomplished using laser cutting. For example, at least a portion of the connection part 330 may be cut using the laser cutting to separate the fixing part 320 from the sensor part 310.

In an embodiment, when the connection part 330 is removed from the printed circuit board 300, the sensor part 310 is no longer restricted in movement by the fixing part 320, and thus may move relatively freely.

In an embodiment, the connector 350 may be connected to one region of the printed circuit board 300. For example, the connector 350 may be connected to the fixing part 320 of the printed circuit board 300 via a connector connection part 351. The connector connection part 351 may be formed to extend between the fixing part 320 and the connector 350. The connector 350 may serve to electrically connect the printed circuit board 300 with an external electronic component (e.g., a main printed circuit board on which a processor is mounted).

In an embodiment, the flexible part 340 may be formed to have resistance against external forces. When the flexible part 340 is formed to have relatively strong resistance to external forces, the operation of the electronic device 200 may require a relatively large current.

In the printed circuit board 300 according to an embodiment of the disclosure, the position of the sensor part 310 is fixed by the fixing part 320, thereby allowing the resistance of the flexible part 340 to be relatively low compared to the case where the position of the sensor part 310 is fixed by the flexible part 340. In the printed circuit board 300 according to an embodiment of the disclosure, the resistance of the flexible part 340 is relatively low, thereby reducing the amount of current required for the operation of the electronic device 200.

In an embodiment, the width of the flexible part 340 may be formed to vary at least in part along the direction in which the flexible part 340 extends. The width of the flexible part 340 may refer to the length of the flexible part 340 formed perpendicular to the direction in which the flexible part 340 extends. Referring to FIG. 4, the width of the flexible part 340 may be formed smaller in at least some regions than in other regions. For example, the width of the flexible part 340 positioned close to the first fixing part 320-1 may be formed to be smaller than the width of the flexible part 340 positioned close to the second fixing part 320-2. The width of the flexible part 340 positioned close to the first fixing part 320-1 may be formed relatively small compared to the other regions, and may form a space in which the first fixing part 320-1 may be disposed.

In an embodiment, the flexible part 340 may include a conductor which allows a current to flow therein. The sensor part 310 may be electrically connected to a region other than the sensor part 310 via the flexible part 340.

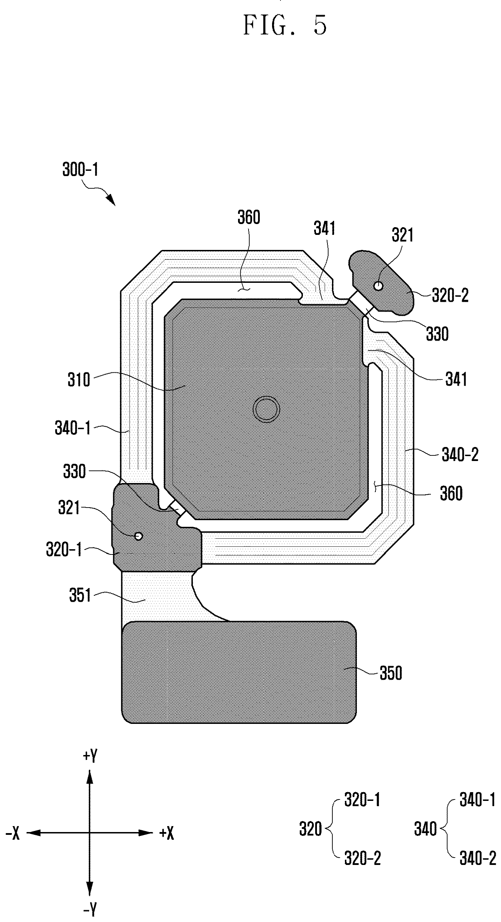

FIG. 5 illustrates a printed circuit board 300-1 including a fixing part 320 spaced apart from the perimeter of a flexible part 340 according to an embodiment of the disclosure.

In describing the printed circuit board 300-1 according to an embodiment of the disclosure, the width direction of the printed circuit board 300-1 may refer to the x-axis direction, and the length direction of the printed circuit board 300-1 may refer to the y-axis direction.

The printed circuit board 300-1 illustrated in FIG. 5 may refer to the printed circuit board 260 in FIG. 2, or may include at least a portion of the printed circuit board 260 in FIG. 2.

The printed circuit board 300-1 illustrated in FIG. 5 may include a sensor part 310, a fixing part 320, a connection part 330, a flexible part 340, and/or a connector 350.

In describing the printed circuit board 300-1 in FIG. 5, elements substantially identical to those of the printed circuit board 300 in FIG. 4 are given the same reference numerals, and detailed descriptions of the substantially identical elements may be omitted.

The sensor part 310, the fixing part 320, the connection part 330, the flexible part 340, and the connector 350 of the printed circuit board 300-1 illustrated in FIG. 5 may be configured to have substantially the same functions as the sensor part 310, the fixing part 320, the connection part 330, the flexible part 340, and the connector 350 of the printed circuit board 300 illustrated in FIG. 4, respectively.

In the printed circuit board 300-1 according to an embodiment of the disclosure, the fixing part 320 and the flexible part 340 may be disposed outside the sensor part 310.

In the printed circuit board 300-1 according to an embodiment of the disclosure, the flexible part 340 may be disposed while surrounding at least a portion of the outer perimeter of the sensor part 310. For example, the flexible part 340 may be formed to extend in the width direction and length direction of the printed circuit board 300-1 outside the perimeter of the sensor part 310.

In the printed circuit board 300-1 according to an embodiment of the disclosure, the flexible part 340 may include a connection region 341 that is connected to the sensor part 310.

The flexible part 340 according to an embodiment of the disclosure may include a first flexible part 340-1 and/or a second flexible part 340-2. The first flexible part 340-1 may be disposed in one direction (e.g., the negative x-axis direction) of the sensor part 310. The second flexible part 340-2 may be disposed in the other direction (e.g., the positive x-axis direction) of the sensor part 310.

In an embodiment, the first flexible part 340-1 and the second flexible part 340-2 may extend along the width direction (e.g., the x-axis direction) and the length direction (e.g., the y-axis direction) of the printed circuit board 300-1.

In an embodiment, each of the first flexible part 340-1 and the second flexible part 340-2 may extend while being bent in at least a portion thereof. For example, the first flexible part 340-1 and the second flexible part 340-2 may extend in the width direction (e.g., the x-axis direction) of the printed circuit board 300-1, is bent in at least a portion, and extend in the length direction (e.g., the y-axis direction) of the printed circuit board 300-1.

The fixing part 320 of the printed circuit board 300-1 according to an embodiment of the disclosure may include a first fixing part 320-1 and/or a second fixing part 320-2.

In an embodiment, the first fixing part 320-1 may be positioned opposite to the second fixing part 320-2 with respect to the sensor part 310. For example, referring to FIG. 5, the first fixing part 320-1 may be disposed at a position that is spaced apart from the sensor part 310 in the negative x-axis direction and the negative y-axis direction. The second fixing part 320-2 may be disposed at a position that is spaced apart from the sensor part 310 in the positive x-axis direction and the positive y-axis direction.

In the printed circuit board 300-1 according to an embodiment of the disclosure, the flexible part 340 may be connected, at one end thereof, to the fixing part 320 and may be connected, at the other end thereof, to the sensor part 310. For example, the first flexible part 340-1 may be connected, at one end thereof, to one end of the first fixing part 320-1 and may be connected, at the other end thereof, to the sensor part 310. The second flexible part 340-2 may be connected, at one end thereof, to the other end of the first fixing part 320-1, and may be connected , at the other end thereof, to the sensor part 310.

In an embodiment, the second fixing part 320-2 may be spaced apart from the flexible part 340. For example, the second fixing part 320-2 may be spaced apart from the first flexible part 340-1 in the width direction (e.g., the x-axis direction) of the printed circuit board 300-1. The second fixing part 320-2 may be spaced apart from the second flexible part 340-2 in the length direction (e.g., the y-axis direction) of the printed circuit board 300-1.

In an embodiment, at least a portion of the fixing part 320 and at least a portion of the flexible part 340 may be disposed on substantially the same line. For example, a portion of the first fixing part 320-1 (e.g., the positive y-axis end of the first fixing part 320-1) may be disposed on the substantially the same line together with a region of the first flexible part 340-1 extending in the y-axis direction. Another portion of the first fixing part 320-1 (e.g., the positive x-axis end of the first fixing part 320-1) may be disposed on substantially the same line together with a region of the second flexible part 340-2 extending in the x-axis direction. A portion of the second fixing part 320-2 (e.g., the negative x-axis end of the second fixing part 320-2) may be disposed on substantially the same line together with a region of the first flexible part 340-1 extending in the x-axis direction. Another portion of the second fixing part 320-2 (e.g., the negative y-axis end of the second fixing part 320-2) may be disposed on substantially the same line together with a region of the second flexible part 340-2 extending in the y-axis direction.

In an embodiment, at least a portion of the fixing part 320 and at least a portion of the flexible part 340 are disposed on substantially the same line, and thus the distance by which the at least a portion of the fixing part 320 is spaced apart from the senor part 310 may be formed to be substantially equal to the distance by which the at least a portion of the flexible part 340 is spaced from the sensor part 310. For example, the distance by which at least a portion of the first fixing part 320-1 is spaced apart from the sensor part 310 in the negative x-axis direction may be formed to be substantially equal to the distance by which a region of the first flexible part 340-1 extending in the y-axis direction is spaced apart from the sensor part 310 in the negative x-axis direction. The distance by which at least a portion of the second fixing part 320-2 is spaced apart from the sensor part 310 in the positive x-axis direction may be formed to be substantially equal to the distance by which a region of the second flexible part 340-2 extending in the y-axis is spaced apart from the sensor part 310 in the positive x-axis direction.

The printed circuit board 300-1 according to an embodiment may include an inner region 360 surrounded by the sensor part 310, the first fixing part 320-1, and the flexible part 340. For example, the sensor part 310, the first fixing part 320-1, and the flexible part 340 may be arranged to surround the inner region 360.

The second fixing part 320-2 of the printed circuit board 300-1 according to an embodiment may be disposed outside the inner region 360. For example, the second fixing part 320-2 may be disposed outside the inner region 360 surrounded by the sensor part 310, the first fixing part 320-1, and the flexible part 340.

Referring to FIG. 5, the first fixing part 320-1 may have at least a portion which is connected to the sensor part 310 via a connection part 330. For example, the connection part 330 may extend from the first fixing part 320-1 in a direction toward the sensor part 310 (e.g., in a direction tilted from the positive y-axis direction toward the positive x-axis direction).

Referring to FIG. 5, the second fixing part 320-2 may have at least a portion which is connected to the sensor part 310 via a connection part 330. For example, the connection part 330 may extend from the second fixing part 320-2 in a direction toward the sensor part 310 (e.g., in a direction tilted from the negative y-axis direction toward the negative x-axis direction).

In an embodiment, after the coupling of the printed circuit board 300 to another region (e.g., the housing 210) of the electronic device 200 is complete, the connection part 330 may be removed. For example, after the coupling of the printed circuit board 300 to the other region of the electronic device 200 is complete, the connection part 330 may be cut to separate the fixing part 320 from the sensor part 310.

In an embodiment, the connector 350 may be connected to one region of the printed circuit board 300-1. For example, the connector 350 may be connected to the first fixing part 320-1 of the printed circuit board 300-1 via the connector connection part 351. Referring to FIG. 5, the connector connection part 351 may be formed between the first fixing part 320-1 and the connector 350 while extending in the longitudinal direction (e.g., the y-axis direction) of the printed circuit board 300-1.

In an embodiment, the connector 350 may serve to electrically connect the printed circuit board 300-1 to an external electronic component (e.g., a main printed circuit board on which a processor is mounted).

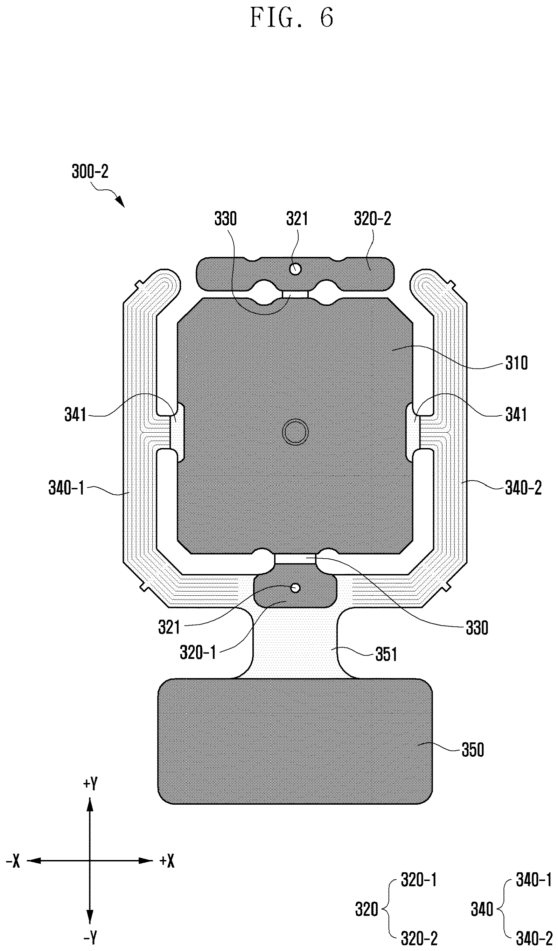

FIG. 6 illustrates a printed circuit board 300-2 including a flexible part 320 that is at least partially open according to an embodiment of the disclosure.

In describing the printed circuit board 300-1 according to an embodiment of the disclosure, the width direction of the printed circuit board 300-2 may refer to the x-axis direction, and the length direction of the printed circuit board 300-2 may refer to the y-axis direction.

The printed circuit board 300-2 illustrated in FIG. 6 may refer to the printed circuit board 260 in FIG. 2, or may include at least a portion of the printed circuit board 260 in FIG. 2.

The printed circuit board 300-2 illustrated in FIG. 6 may include a sensor part 310, a fixing part 320, a connection part 330, a flexible part 340, and/or a connector 350.

In describing the printed circuit board 300-2 in FIG. 6, elements substantially identical to those of the printed circuit board 300 in FIG. 4 are given the same reference numerals, and detailed descriptions of the substantially identical elements may be omitted.

The sensor part 310, the fixing part 320, the connection part 330, the flexible part 340, and the connector 350 of the printed circuit board 300-2 illustrated in FIG. 6 may be configured to have substantially the same functions as the sensor part 310, the fixing part 320, the connection part 330, the flexible part 340, and the connector 350 of the printed circuit board 300 illustrated in FIG. 4, respectively.

In the printed circuit board 300-2 according to an embodiment of the disclosure, the fixing part 320 and the flexible part 340 may be disposed outside the sensor part 310.

In the printed circuit board 300-2 according to an embodiment of the disclosure, the flexible part 340 may be disposed while surrounding at least a portion of the outer perimeter of the sensor part 310. For example, the flexible part 340 may be formed to extend in the width direction and length direction of the printed circuit board 300-2 outside the perimeter of the sensor part 310.

In the printed circuit board 300-2 according to an embodiment of the disclosure, the flexible part 340 may include a connection region 341 that is connected to the sensor part 310.

The flexible part 340 according to an embodiment of the disclosure may include a first flexible part 340-1 and/or a second flexible part 340-2. The first flexible part 340-1 may be disposed in one direction (e.g., the negative x-axis direction) of the sensor part 310. The second flexible part 340-2 may be disposed in the other direction (e.g., the positive x-axis direction) of the sensor part 310.

In an embodiment, the first flexible part 340-1 and the second flexible part 340-2 may extend along the width direction (e.g., the x-axis direction) and the length direction (e.g., the y-axis direction) of the printed circuit board 300-2.

In an embodiment, each of the first flexible part 340-1 and the second flexible part 340-2 may extend while being bent in at least a portion thereof. For example, the first flexible part 340-1 and the second flexible part 340-2 may extend in the width direction of the printed circuit board 300-2, is bent in at least a portion, and extend in the length direction of the printed circuit board 300-2.

In an embodiment, the flexible part 340 may be connected to the sensor part 310 at the connection region 341. The flexible part 340 may include the connection region 341 extending from the flexible part 340 in a direction toward the sensor part 310, and may be connected to the sensor part 310 at the connection region 341. Each of the first flexible part 340-1 and the second flexible part 340-2 may be connected to the sensor part 310 at the connection region 341.

The fixing part 320 of the printed circuit board 300-2 according to an embodiment of the disclosure may include a first fixing part 320-1 and/or a second fixing part 320-2.

In an embodiment, the first fixing part 320-1 may be positioned opposite to the second fixing part 320-2 relative to the sensor part 310. For example, referring to FIG. 6, the first fixing part 320-1 may be disposed at a position spaced apart from the sensor part 310 in the negative y-axis direction. The second fixing part 320-2 may be disposed at a position spaced apart from the sensor part 310 in the positive y-axis direction.

In the printed circuit board 300-2 according to an embodiment of the disclosure, the flexible part 340 may be connected, at one end thereof, to the first fixing part 320-1 and spaced apart, at the other end thereof, from the second fixing part 320-2. For example, the first flexible part 340-1 may be connected to one end of the first fixing part 320-1 (e.g., an end of the first fixing part 320-1 facing the negative x-axis direction) at one end of the first flexible part 340-1and may be spaced apart from the second fixing part 320-2 at the other end of the first flexible part 340-1 in the width direction (e.g., the x-axis direction) of the printed circuit board 300-2. The second flexible part 340-2 may be connected to the other end of the first fixing part 320-1 (e.g., an end of the first fixing part 320-1 facing the positive x-axis direction) at one end of the second flexible part 340-2, and may be spaced apart from the second fixing part 320-2 at the other end of the second flexible part 340-2 in the width direction (e.g., the x-axis direction) of the printed circuit board 300-2.

In an embodiment, the second fixing part 320-2 may be spaced apart from the flexible part 340. For example, the second fixing part 320-2 may be positioned between the first flexible part 340-1 and the second flexible part 340-2. The second fixing part 320-2 may be spaced apart from the end of the first flexible part 340-1 in the positive x-axis direction. The second fixing part 320-2 may be spaced apart from the end of the second flexible part 340-2 in the negative x-axis direction.

In the printed circuit board 300-2 according to an embodiment, the flexible part 340 may be at least partially open. An open state of the flexible part 340 may imply that the ends of the flexible part 340 are spaced apart from and not connected to other regions of the printed circuit board 300-2. Referring to FIG. 6, in the printed circuit board 300-2 according to an embodiment, the ends of the first flexible part 340-1 and the ends of the second flexible part 340-2 may be spaced apart and not connected to other regions of the printed circuit board 300-2.

In an embodiment, at least a portion of the fixing part 320 and at least a portion of the flexible part 340 may be disposed on substantially the same line. For example, a portion of the first fixing part 320-1 may be disposed on substantially the same line together with the first flexible part 340-1 and the second flexible part 340-2 which are connected to the first fixing part 320-1. A portion of the second fixing part 320-2 may be disposed on substantially the same line together with the end of the first flexible part 340-1 (e.g., the end of the first flexible part 340-1 positioned in a direction toward the second fixing part 320-2) and the end of the second flexible part 340-2 (e.g., the end of the second flexible part 340-2 positioned in a direction toward the second fixing part 320-2).

In an embodiment, at least a portion of the fixing part 320 and at least a portion of the flexible part 340 are disposed on substantially the same line, and thus the distance by which the at least a portion of the fixing part 320 is spaced apart from the senor part 310 may be formed to be substantially equal to the distance by which the at least a portion of the flexible part 340 is spaced from the sensor part 310. For example, the distance by which at least a portion of the first fixing part 320-1 is spaced apart from the sensor part 310 in the negative y-axis direction may be formed to be substantially equal to the distance by which the first flexible part 340-1 and the second flexible part 340-2 is spaced apart from the sensor part 310 in the negative y-axis direction. The distance by which at least a portion of the second fixing part 320-2 is spaced apart from the sensor part 310 in the positive y-axis direction may be formed to be substantially equal to the distance by which the end of the first flexible part 340-1 (e.g., the end of the first flexible part 340-1 positioned in a direction toward the second fixing part 320-2) and the end of the second flexible part 340-2 (e.g., the end of the second flexible part 340-2 positioned in a direction toward the second fixing part 320-2) are spaced apart from the sensor part 310 in the positive y-axis direction.

Referring to FIG. 6, the first fixing part 320-1 may be connected, in at least a portion thereof, to the sensor part 310 via the connection part 330. For example, the connection part 330 may extend from at least a portion of the first fixing part 320-1 in a direction toward the sensor part 310 (e.g., in the positive y-axis direction).

Referring to FIG. 6, the second fixing part 320-2 may be connected, in at least a portion thereof, to the sensor part 310 via the connection part 330. For example, the connection part 330 may extend from the second fixing part 320-2 in a direction toward the sensor part 310 (e.g., in the negative y-axis direction).

In an embodiment, the connection part 330 may be removed after the coupling of the printed circuit board 300-2 to another region (e.g., the housing 210, see FIG. 2) of the electronic device 200 is complete. For example, after the coupling of the printed circuit board 300-2 to the other region of the electronic device 200 is complete, the connection part 330 may be cut to separate the fixing part 320 from the sensor part 310.

In an embodiment, the connector 350 may be connected to one region of the printed circuit board 300-2. For example, the connector 350 may be connected to the first fixing part 320-1 of the printed circuit board 300-2 via a connector connection part 351. Referring to FIG. 6, the connector connection part 351 may be formed between the first fixing part 320-1 and the connector 350 while extending in the longitudinal direction (e.g., the y-axis direction) of the printed circuit board 300-2

In an embodiment, the connector 350 may serve to electrically connect the printed circuit board 300-2 to an external electronic component (e.g., a main printed circuit board on which a processor is mounted).

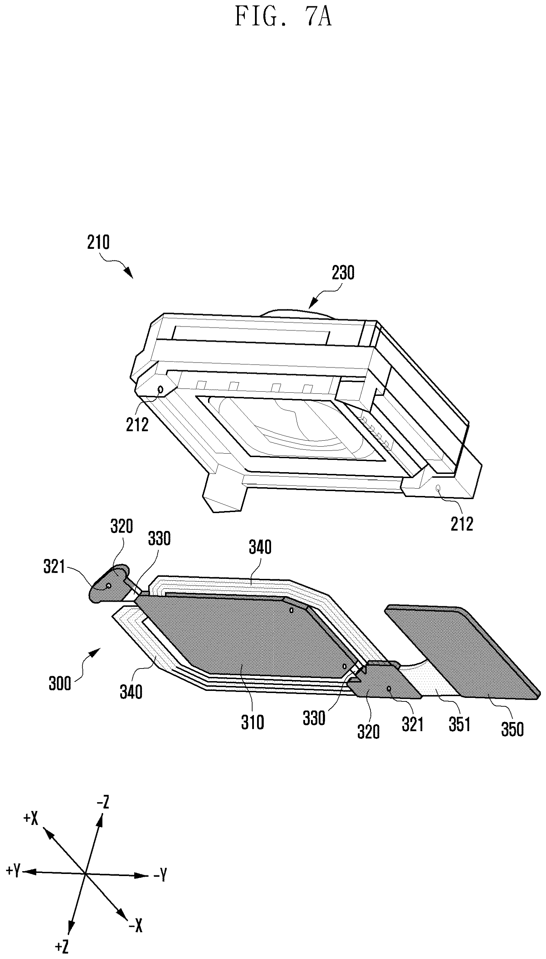

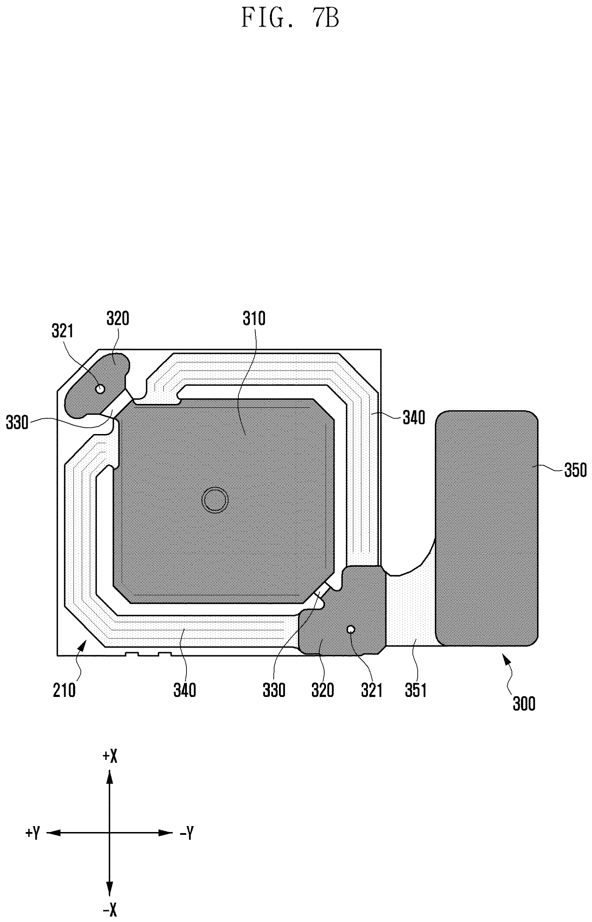

FIGS. 7A and 7B illustrate a housing 210 and a printed circuit board 300 according to an embodiment of the disclosure.

FIG. 7A illustrates a state before the printed circuit board 300 and the housing 210 according to an embodiment are coupled to each other. FIG. 7B illustrates a state in which the printed circuit board 300 according to an embodiment is disposed in the housing 210.

The printed circuit board 300 illustrated in FIGS. 7A and 7B may refer to the printed circuit board 300-1 according to an embodiment illustrated in FIG. 5.

In an embodiment, a driving part 230 may be disposed in at least a portion of the housing 210. Referring to FIG. 7A, the housing 210 and the printed circuit board 300 may be coupled to each other while the driving part 230 is disposed in the housing 210.

Referring to FIGS. 7A and 7B, the printed circuit board 300 according to an embodiment may be coupled to the housing 210 in at least a portion thereof. For example, a fixing part 320 of the printed circuit board 300 may be coupled to the housing 210.

In an embodiment, the housing 210 may include a coupling region 212. The coupling region 212 may be a region where a portion of the housing 210 protrudes and extends in one direction (e.g., the positive z-axis direction) of the housing 210.

In an embodiment, the fixing part 320 of the printed circuit board 300 may include a fixing part hole 321.

In an embodiment, when the housing 210 is coupled to the fixing part 320, the coupling region 212 of the housing 210 may be inserted into the fixing part hole 321 of the fixing part 320. When the coupling region 212 is inserted and fixed in the fixing part hole 321, the housing 210 and the printed circuit board 300 may be coupled to each other and fixed.

In an embodiment, when the fixing part 320 includes the fixing part hole 321, the coupling region 212 of the housing 210 may be easily fixed to the fixing part 320, thereby facilitating coupling of the housing 210 and the printed circuit board 300.

Referring to FIGS. 7A and 7B, when the printed circuit board 300 and the housing 210 are coupled to each other, at least a portion of the printed circuit board 300 may be disposed in one direction of the housing 210. For example, the remaining region of the printed circuit board 300, other than a connector 350 and a connector connection part 351, may be disposed in the positive z-axis direction relative to the housing 210.

In an embodiment, after the printed circuit board 300 and the housing 210 are coupled to each other, a connection part 330 of the printed circuit board 300 may be removed.

In an embodiment, when the connection part 330 is removed, the fixing part 320 may be separated from a sensor part 310. For example, when the connection part 330 is removed, the sensor part 310 may be disposed to be directly connected to a flexible part 340 but disconnected from the fixing part 320.

In an embodiment, when the connection part 330 is removed, the sensor part 310 may move relatively freely because movement of the sensor part 310 is not restricted by the fixing part 320. After the connection part 330 is removed, the sensor part 310 may move in response to movement of the driving part 230.

An electronic device 200 according to an embodiment of the disclosure may include a driving part 230, a housing 210, and a printed circuit board 260 or 300. In an embodiment, the driving part 230 may include a camera lens 231. In an embodiment, the driving part 230 may be disposed in the housing 210, and the housing 210 may surround the perimeter of the driving part 230. In an embodiment, the printed circuit board 260 or 300 may be disposed on at least a portion of the housing 210 and the driving part 230.

In an embodiment, the printed circuit board 300 may include a sensor part 310, a fixing part 320, a connection part 330, and a flexible part 340. In an embodiment, the fixing part 320 may be coupled to the housing 210. In an embodiment, the connection part 330 may extend while connecting the fixing part 320 and the sensor part 310. In an embodiment, the flexible part 340 may extend while surrounding at least a portion of the outer perimeter of the sensor part 310 and may be connected to the sensor part 310 and the fixing part 320.

In an embodiment, the connection part 330 may be cut when the housing 210 is coupled to the fixing part 320.

In an embodiment, the housing 210 may include a protrusion region 212 that protrudes in a direction toward the fixing part 320.

In an embodiment, the fixing part 320 may include a fixing part hole 321 into which the protrusion region 212 of the housing 210 is inserted.

In an embodiment, when the housing 210 is coupled to the fixing part 320, the protrusion region 212 may be inserted into and fixed to the fixing part hole 321.

In an embodiment, the protrusion region 212 of the housing 210 may be disposed at a distance from the outermost edge of the housing 210 in a direction toward the inner side of the housing 210.

In an embodiment, the fixing part 320 and the flexible part 340 are disposed in an outward direction of the sensor part 310, and at least a portion of the fixing part 320 may be positioned closer to the sensor part 310 than the flexible part 340.

In an embodiment, the printed circuit board 300 may include three fixing parts 320.

In an embodiment, two fixing parts 320-1 among the three fixing parts 320 may be disposed between the sensor part 310 and the flexible part 340, and one remaining fixing part 320-2 may be connected to the flexible part 340 at one end and the other end thereof, and a distance by which at least a portion of the fixing part 320-2 is spaced apart from the sensor part 310 may be equal to a distance by which at least a portion of the flexible part 340 is spaced apart from the sensor part 310.

In an embodiment, the printed circuit board 300 may be formed such that the width of the flexible part 340 close to the two fixing parts 320-1 is smaller than the width of the flexible part 340 close to the one remaining fixing part 320-2.

In an embodiment, the fixing part 320 and the flexible part 340 are disposed in an outward direction of the sensor part 310, and a distance by which at least a portion of the fixing part 320 is spaced apart from the sensor part 310 may be equal to a distance by which at least a portion of the flexible part 340 is spaced apart from the sensor part 310.

In an embodiment, the printed circuit board 300-1 or 300-2 may include two fixing parts 320, wherein one fixing part 320-1 is connected to the flexible part 340 at one end and the other end thereof, and the other fixing part 320-2 may be spaced apart from the flexible part 340.

In an embodiment, the printed circuit board 300-1 may include two flexible parts 340.

Each of the two flexible parts 340 may be connected to the one fixing part 320-1 at one end of the flexible part 340, and may be connected to the sensor part 310 at the other end of the flexible part 340.

In an embodiment, the printed circuit board 300-2 may include two flexible parts 340, and each of the two flexible parts 340 may be connected to the one fixing part 320-1 at one end of the flexible part 340 and spaced apart from the sensor part 310 and the other fixing part 320-2 at the other end of the flexible part 340.

In an embodiment, the printed circuit board 300 may include a connector 350 connected to at least a portion of the fixing part 320 and configured to electrically connect the printed circuit board 300 to an electronic component positioned outside the printed circuit board 300.

In an embodiment, the flexible part 340 may include a conductor which allows a current to flow therein.

In an embodiment, after the connection part 330 is cut, the sensor part 310 may move in a direction in which the driving part 230 moves.

In an embodiment, the electronic device 200 may include a bottom cover 270 disposed in one direction of the printed circuit board 260.

In an embodiment, the printed circuit board 260 may be coupled to the housing 210 in which the camera lens 231 is disposed.

The electronic device 200 according to an embodiment of the disclosure may include the printed circuit board 300 coupled to the housing 210 in which the camera lens 231 is disposed.

The printed circuit board 300 according to an embodiment of the disclosure may be coupled to the housing 210 in which the camera lens 231 is disposed.

In an embodiment, the driving part 230 may include a coil 232. In an embodiment, the camera lens 231 of the driving part 230 may be rotated or moved using electromagnetic force generated by the coil 232.

In an embodiment, the sensor part 310 of the printed circuit board 300 may be tilted in a direction in which the camera lens 231 is tilted.

The electronic device according to an embodiment of the disclosure may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in an embodiment of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

An embodiment of the disclosure may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions each may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may also be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device (200) comprising:
a driving part (230) comprising a camera lens 231;
a housing (210) in which the driving part is disposed and which is configured to surround the perimeter of the driving part;
a printed circuit board (260 or 300) disposed in at least a portion of the housing and the driving part,
wherein the printed circuit board (300) comprises:
a sensor part (310);
a fixing part (320) coupled to the housing;
a connection part (330) extending while connecting the fixing part to the sensor part; and
a flexible part (340) which extends while surrounding at least a portion of the outer perimeter of the sensor part and is connected to the sensor part and the fixing part, and
wherein the connection part is cut in case that the housing is coupled to the fixing part.

2. The electronic device of claim 1, wherein the housing comprises a protrusion region (212) that protrudes in a direction toward the fixing part,
wherein the fixing part comprises a fixing part hole (321) into which the protrusion region of the housing is inserted, and
wherein in case that the housing is coupled to the fixing part, the protrusion region is inserted into and fixed to the fixing part hole.

3. The electronic device of one of claims 1 and 2, wherein the protrusion region of the housing is disposed at a distance from the outermost edge of the housing in a direction toward the inner side of the housing.

4. The electronic device of one of claims 1 to 3, wherein the fixing part and the flexible part are disposed in an outward direction of the sensor part, and at least a portion of the fixing part is positioned closer to the sensor part than the flexible part.

5. The electronic device of claim 4, wherein the printed circuit board (300) comprises three fixing parts,
wherein two fixing parts (320-1) among the fixing parts are disposed between the sensor part and the flexible part, and
wherein one remaining fixing part (320-2) among the fixing parts is connected to the flexible part at one end and the other end thereof, and a distance by which at least a portion of the fixing part is spaced apart from the sensor part is equal to a distance by which at least a portion of the flexible part is spaced apart from the sensor part.

6. The electronic device of claim 5, wherein the printed circuit board is formed such that the width of the flexible part positioned close to the two fixing parts among the fixing parts is smaller than the width of the flexible part positioned close to the one remaining fixing part among the fixing parts.

7. The electronic device of one of claims 1 to 6, wherein the fixing part and the flexible part are disposed in an outward direction of the sensor part, and a distance by which at least a portion of the fixing part is spaced apart from the sensor part is equal to a distance by which at least a portion of the flexible part is spaced apart from the sensor part.

8. The electronic device of claim 7, wherein the printed circuit board (300-1 or 300-2) comprises two fixing parts, and
wherein one fixing part (320-1) among the fixing parts is connected to the flexible part at one end and the other end thereof, and the other fixing part (320-2) among the fixing parts is spaced apart from the flexible part.

9. The electronic device of claim 8, wherein the printed circuit board (300-1) comprises two flexible parts, and
wherein each of the two flexible parts is connected to the one fixing part at one end of the flexible part, and is connected to the sensor part at the other end of the flexible part.

10. The electronic device of claim 8, wherein the printed circuit board (300-2) comprises two flexible parts, and
wherein each of the two flexible parts is connected to the one fixing part at one end of the flexible part and is spaced apart from the sensor part and the other fixing part at the other end of the flexible part.

11. The electronic device of one of claims 1 to 10, wherein the printed circuit board further comprises a connector (350) connected to at least a portion of the fixing part and configured to electrically connect the printed circuit board to an electronic component positioned outside the printed circuit board.

12. The electronic device of one of claims 1 to 11, wherein the flexible part comprises a conductor which allows a current to flow therein.

13. The electronic device of one of claims 1 to 12, wherein the sensor part is configured to move, after the connection part is cut, in a direction in which the driving part moves.

14. The electronic device of one of claims 1 to 13, further comprising a bottom cover (270) disposed in one direction of the printed circuit board.

15. The electronic device of one of claims 1 to 14, wherein the driving part further comprises a coil 232,
wherein the camera lens of the driving part is configured to be rotated or moved using electromagnetic force generated by the coil, and
wherein the sensor part of the printed circuit board is configured to tilt in a direction in which the camera lens is tilted.
